Europäisches Patentamt

European Patent Office

Office européen des brevets

(19)

(11) **EP 0 645 607 B1**

(12) **EUROPÄISCHE PATENTSCHRIFT**

(45) Veröffentlichungstag und Bekanntmachung des Hinweises auf die Patenterteilung:
**04.06.1997  Patentblatt 1997/23**

(51) Int Cl.6: **G01D 5/36**, H03M 1/22

(21) Anmeldenummer: **93112703.9**

(22) Anmeldetag: **07.08.1993**

(54) **Vorrichtung zur Erzeugung oberwellenfreier periodischer Signale**

Apparatus for producing harmonic-free periodic signals

Dispositif de production de signaux périodiques sans harmonie

(84) Benannte Vertragsstaaten:
**DE FR GB**

(43) Veröffentlichungstag der Anmeldung:
**29.03.1995  Patentblatt 1995/13**

(73) Patentinhaber: **Dr. Johannes Heidenhain GmbH
D-83292 Traunreut (DE)**

(72) Erfinder:
• **Franz, Andreas, Dr.
D-83308 Trostberg (DE)**
• **Holzappel, Wolfgang, Dr.
D-83119 Obing (DE)**

(56) Entgegenhaltungen:
DE-B- 1 941 731          DE-C- 3 239 108
DE-C- 3 412 128

**Beschreibung**

Die Erfindung bezieht sich auf eine Vorrichtung gemäß dem Oberbegriff des Anspruches 1.

Derartige Vorrichtungen werden zur Messung von Lageänderungen zweier relativ zueinander beweglicher Objekte benötigt. Dabei werden die unterschiedlichsten physikalischen Abtastprinzipien benutzt. Man unterscheidet zwischen fotoelektrischer, magnetischer, induktiver und kapazitiver Abtastung.

Das Grundprinzip ist jedoch allen Methoden gemeinsam: Eine periodische Meßteilung wird abgetastet und das so erzeugte Abtastsignal wird als Meßsignal ausgewertet.

Die Periode der gewonnenen Abtastsignale wird durch die Teilungsperiode oder das Inkrement der Teilung des Teilungsträgers bestimmt. Das Inkrement wird bei fotoelektrischen Meßeinrichtungen durch die Breiten eines lichtdurchlässigen Streifens und eines lichtundurchlässigen Streifens in Meßrichtung gebildet. Bei der Relativbewegung zwischen der Abtasteinheit und der Meßteilung des Teilungsträgers wird von jedem abgetasteten Inkrement ein Zählimpuls abgeleitet, vorzeichenrichtig aufsummiert und die Summe steht als Meßwert zur Verfügung.

Die aus den Teilungen der Teilungsträger bei fotoelektrischen, magnetischen, induktiven und kapazitiven Meßeinrichtungen gewonnenen periodischen logsignale weisen im allgemeinen keinen reinen nusförmigen Verlauf auf, sondern sind beispielsweise infolge von Ungenauigkeiten der Teilungen wellenbehaftet. Diese Ungenauigkeiten der Teilungen werden zum Beispiel durch unterschiedliche Abstände der lichtdurchlässigen und lichtundurchlässigen Streifen oder durch eine Kantenunschärfe dieser Streifen hervorgerufen. Um die gewonnenen Analogsignale weitgehend oberwellenfrei zu halten, müssen hohe Anforderungen an die Genauigkeit der Teilungen gestellt werden. Zur Bildung von genauen Positionsmeßwerten für jede Teilungsperiode und um zur weiteren Erhöhung der Auflösung die Teilungsperioden der Teilung durch Bildung von Interpolationswerten exakt unterteilen zu können, muß das aus dieser Teilung gewonnene Analogsignal oberwellenfrei sein; eine Bildung von Interpolationswerten beispielsweise mittels eines Rechners ist in der DE-OS 27 29 697 beschrieben.

Weiterhin sind Meßeinrichtungen bekannt, die dreieckförmige oder trapezförmige Analogsignale liefern, die naturgemäß stets oberwellenbehaftet sind.

Aus der DE-PS 19 41 731 ist eine fotoelektrische Längenmeßeinrichtung bekannt, bei der zur Gewinnung eines oberwellenfreien Analogsignals bei der Abtastung der Teilung eines Teilungsträgers eine quenzfilterblende mit einem sinusförmigen sigkeitsverlauf vorgesehen ist. Bei dieser Meßeinrichtung muß eine spezielle Frequenzfilterblende hergestellt und eingebaut werden. Zudem ist diese Meßeinrichtung auf das fotoelektrische Durchlichtmeßprinzip beschränkt, bei dem ein aus periodischen Helligkeitsschwankungen aufgebautes Streifensystem nach den sogenannten Vernier- oder Moireprinzipien erzeugt wird.

Zur Gewinnung oberwellenfreier periodischer Signale wird in der DE 32 39 108 C2 vorgeschlagen, die Bandbreite (Anzahl der Frequenzen oder Wellen) des Analogsignals zu ermitteln, die Teilungsperiode der Teilung jeweils mit Abtastelementen abzutasten, die von den Abtastelementen gelieferten periodischen Analogsignale zur Ermittlung von Fourierkoeffizienten der Grundwelle des Analogsignals einer Fourieranalyse zu unterziehen und die Fourierkoeffizienten als oberwellenfreie periodische Signale zur Bildung von Positionsmeßwerten auszuwerten.

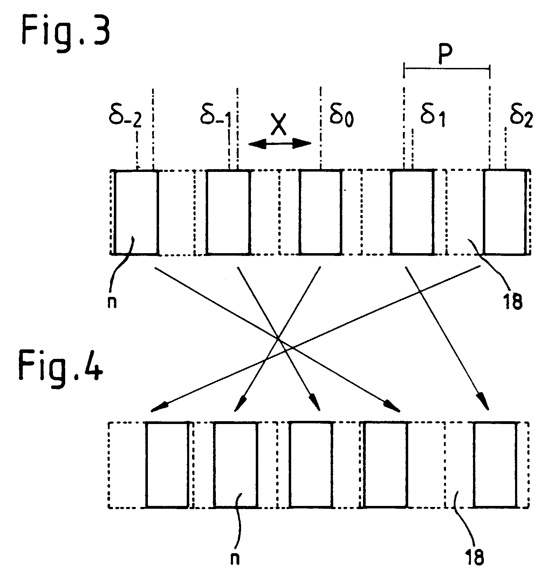

Ein mathematisch äquivalenter, aber ausführungsmäßig völlig anderer Ansatz zur Oberwellenfilterung ist beispielsweise aus der DE 34 12 128 C1 als sogenannte arcsin-Abtastung bekannt. Nach einem ersten Gitter entsteht eine Intensitätsverteilung (Gitterbild im Schattenwurf oder Selbstabbildung in der Talbot-Ebene) die mit einem Gitter variabler Abtast-Teilung abgetastet wird, wie sie in Figur 3 schematisch dargestellt ist. Viele dieser Methoden (z.B. auch Vernier-, Vernier-arcsin-, Mehrfeldfilterung) beruhen auf einer besonderen Abtastteilung, deren Gitterstrich-Positionen $X_n$ (n: Gitterstrich-Index) gegenüber der Nominallage $n*P$ jeweils um einen kleinen Betrag $\delta_n$ verschoben sind: $X_n = n*P + \delta_n$. Diese Verschiebungen $\delta_n$ bewirken eine Phasenverschiebung des zugehörigen Signalanteils und sind so gewählt, daß in der Überlagerung aller Signalanteile einzelne oder alle Oberwellen unterdrückt werden. Die verschiedenen Methoden der Oberwellenfilterung, die auf diesem Prinzip beruhen, besitzen unterschiedliche funktionale Abhängigkeiten zwischen der Verschiebung $\delta_n$ und dem Gitterstrich-Index n. Es gilt z.B.:

Vernier-Filter $\qquad \delta_n = n*\alpha*P \qquad (\alpha << 1)$
arcsin-Filter $\qquad \delta_n = P/2\pi*\arcsin(n/N), n=-N...+N$

Ihnen gemeinsam ist eine stetige Zu- oder Abnahme der Verschiebung $\delta_n$ mit ansteigendem Gitterstrich-Index n. Dies hat zur Folge, daß Signalanteile mit einer größeren Phasendifferenz an weit auseinanderliegenden Abtaststellen erzeugt werden. Eine nenswerte Filterwirkung ist daher nur gewährleistet, wenn die Signalanteile eines relativ großen Abtastbereiches gleichmäßig und ohne Störungen überlagert werden.

In der Praxis treten aber häufig Störungen auf, die die Filterwirkung stark beeinträchtigen:

- ungleichmäßige Bleuchtungsintensität innerhalb der Abtastteilung;

- Beleuchtung der Abtastteilung durch ein dekollimiertes (divergentes oder konvergentes) Lichtbündel;

- lokale Fehlstellen in der Abtast- oder Maßstabteilung;

Diese Störungen reduzieren nicht nur die Filterwirkung, sie verschieben auch die Phasenlage des aus den einzelnen phasenverschobenen Anteilen zusammengesetzten Signales und verschlechtern dadurch zusätzlich die Signalqualität.

Aufgabe der Erfindung ist es, eine Vorrichtung zur Oberwellenfilterung anzugeben, die auch bei den oben genannten Störungen eine hohe Filterwirkung behält und die Phasenlage des zusammengesetzten Signales kaum verändert.

Diese Aufgabe wird von einer Vorrichtung gemäß Anspruch 1 gelöst.

Die mit der Erfindung erzielten Vorteile bestehen insbesondere darin, daß auf einfache Weise die Gewinnung oberwellenfreier periodischer Signale lediglich mit abgewandelten herkömmlichen Mitteln bekannter Positionsmeßeinrichtungen ermöglicht wird, ohne daß zusätzliche Elemente wie Frequenzfilterblenden erforderlich sind und ohne daß besondere Anforderungen an die Genauigkeit der Teilung gestellt werden müssen.

Vorteilhafte Weiterbildungen der Erfindung entnimmt man den abhängigen Patentansprüchen. Ein Ausführungsbeispiel der Erfindung wird anhand der Zeichnung näher erläutert.

Es zeigt

Figur 1    eine Längenmeßeinrichtung im Querschnitt;

Figur 2    schematisch eine Abtasteinheit einer fotoelektrischen Längenmeßeinrichtung;

Figur 3    eine Abtastteilung mit terwirkung und

Figur 4    eine Abtastteilung gemäß der Erfindung.

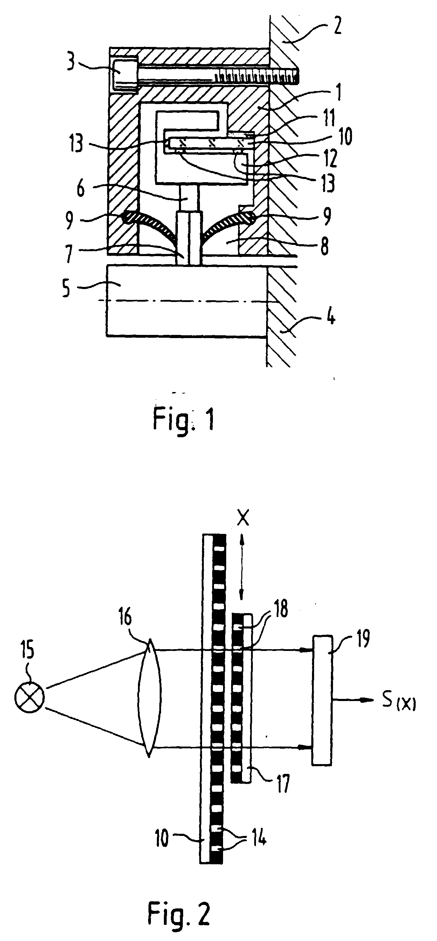

In Figur 1 ist eine Längenmeßeinrichtung im Querschnitt dargestellt, deren Gehäuse 1 in Form eines Hohlprofils an einem Bett 2 einer nicht dargestellten Bearbeitungsmaschine mittels einer Schraubverbindung 3 befestigt ist. An einem Schlitten 4 der Bearbeitungsmaschine ist ein Montagefuß 5 mit einem Mitnehmer 6 in beliebiger Weise befestigt, der über eine schneidenförmige Verjüngung 7 durch einen Schlitz 8 in das im übrigen vollkommen geschlossene Gehäuse 1 hineinragt, wobei im Schlitz 8 vorgesehene elastische Dichtlippen 9 ein Eindringen von Verunreinigungen in das Innere des Gehäuses 1 verhindern. An einer Innenfläche des Gehäuses 1 ist ein Maßstab 10 mittels einer elastischen Klebeschicht 11 angebracht, an dem sich eine Abtasteinheit 12 über Rollen 13 abstützt; die Relativbewegung des Schlittens 4 bezüglich des Betts 2 wird vom Mitnehmer 6 auf die Abtasteinheit 12 übertragen.

Gemäß Figur 2 sind zur Abtastung einer Teilung 14 des Maßstabs 10 in der Abtasteinheit 12 eine Lichtquelle 15, ein Kondensor 16, eine Abtastplatte 17 mit einer Teilung 18 und ein Photoelement 19 angeordnet. Der von der Lichtquelle 15 ausgehende Lichtstrom wird vom Kondensor 16 parallel gerichtet, durchsetzt die Teilungen 14, 18 des Maßstabs 10 und der Abtastplatte 17 und fällt anschließend auf das Photoelement 19. Bei der Bewegung der Abtasteinheit 12 mit der Abtastplatte 17 in Meßrichtung X gegenüber dem feststehenden Maßstab 10 wird der Lichtstrom an den Teilungen 14, 18 moduliert, so daß das Photoelement 19 ein periodisches elektrisches Analogsignal S (X) liefert, das ausgewertet, gezählt und in digitaler Form als Positionsmeßwert zur Anzeige gebracht wird.

Das vom Photoelement 19 gelieferte periodische Analogsignal S (X) ist im allgemeinen z.B. aufgrund von Ungenauigkeiten der Teilungen 14, 18 oberwellenbehaftet und kann als Funktion des Meßweges X durch eine Fourierreihe dargestellt werden.

Für die Oberwellenunterdrückung gemäß der bereits erwähnten arcsin-Funktion nach DE 34 12 128 C1 ist eine nichtperiodische Abtastteilung 18 erforderlich, wie sie in Figur 3 dargestellt ist. Deren einzelne Teilungsmarkierungen (Gitterstriche) n (n=-N bis +N) sind jeweils um einen kleinen Betrag $\delta_n$ in Meßrichtung X verschoben gegenüber der Nennposition einer entsprechend zugeordneten periodischen Meßteilung. Es gilt

$$\delta_n = P/2\pi * \arcsin(n/N).$$

Diese nichtperiodische Abtastteilung 18 erlaubt eine Unterdrückung von Oberwellen.

Die Gitterstrich-Verschiebungen $\delta_n$ sind entsprechend der oben angegebenen Funktion berechnet und bilden deshalb eine "geordnete" Folge.

Die Filterwirkung bleibt unverändert, wenn die Gitterstrich-Verschiebungen $\delta_n$ und $\delta_m$ zweier beliebiger Gitterstriche vertauscht werden: $\delta_n$ -> $\delta_m$, $\delta_m$ -> $\delta_n$. Eine erfindungsgemäße Abtastteilung 18 entsteht nun gemäß Figur 4 dadurch, daß die Folge der Gitterstrich-Verschiebungen gemischt wird. Die Filterwirkung bleibt dabei erhalten, denn die Filterwirkung beruht auf der Häufigkeitsverteilung der Gitterstrich-Verschiebungen, die nicht von der Reihenfolge der Gitterstrich-Verschiebungen abhängt. Eine solche Abtastteilung 18 erzeugt an eng benachbarten Abtaststellen Signalanteile mit einer relativ großen Phasendifferenz. Die in der Praxis auftretenden Störungen beeinträchtigen daher die einzelnen phasenverschobenen Signalanteile weitgehend gleichmäßig, so daß die Filterwirkung erhalten bleibt. Auch verschiebt eine solche Störung nicht mehr nennenswert die Phasenlage des zusammengesetzten Signales.

Das "Mischen" der Gitterstrich-Verschiebungen läßt sich auf alle Filtermethoden, die auf dem Prinzip der Gitterstrich-Verschiebung beruhen (mindestens alle oben genannten Filtermethoden) übertragen. Dieses Mischen kann in einer statistischen Weise erfolgen. Es kann aber auch nach einer (deterministischen) Vorschrift geschehen, solange gewährleistet bleibt, daß die Gitterstrich-Verschiebungen innerhalb eines beliebigen Teilbereiches der Abtastteilung möglichst gleichmäßig verteilten Positionen innerhalb der ursprünglichen, geordneten Folge von Gitterstrich-Verschiebungen entsprechen.

Nicht nur die Reihenfolge der Gitterstrich-Verschiebungen kann im Rahmen dieser Erfindung mischt werden, es können auch die Gitterstrich-Positionen direkt mit Hilfe eines statistischen oder pseudostatistischen Verfahrens bestimmt werden. Die Verteilungsfunktion, d.h. die Wahrscheinlichkeit, daß einem Gitterstrich eine bestimmte Verschiebung zugeordnet wird, muß dabei geeignet gewählt werden. Denn diese bestimmt die Filterwirkung der Abtastteilung. Vorteilhaft sind z.B. rechteckförmige oder kosinusförmige Verteilungsfunktionen.

## Patentansprüche

1. Vorrichtung zur Gewinnung von bis zu einer vorbestimmbaren Bandbreite oberwellenfreien Signalen, die durch Abtastung einer periodischen Meßteilung (14) mit wenigstens einer unperiodischen Abtastteilung (18) erzeugt werden, wobei die Gitterstriche der Abtastteilung (18) gegenüber der periodischen Meßteilung (14) eine Gitterstrich-Verschiebung aufweisen, dadurch gekennzeichnet, daß die Folge der Gitterstrich-Verschiebungen von einer geordneten Reihenfolge abweicht.

2. Vorrichtung nach Anspruch 1, dadurch gekennzeichnet, daß die Gitterstriche (n) untereinander die gleiche Breite aufweisen.

3. Vorrichtung nach Anspruch 1, dadurch gekennzeichnet, daß die unregelmäßige Folge von Gitterstrich-Verschiebungen durch Mischung aus einer geordneten Folge bestimmt wird.

4. Vorrichtung nach Anspruch 3, dadurch gekennzeichnet, daß die Mischung statistisch oder pseudostatistisch erfolgt.

5. Vorrichtung nach Anspruch 1, dadurch gekennzeichnet, daß die unregelmäßige Folge von Gitterstrich-Verschiebungen unmittelbar vorgegeben wird.

6. Vorrichtung nach einem der Ansprüche 1 bis 5, dadurch gekennzeichnet, daß die Häufigkeitsverteilung der Gitterstrich-Verschiebungen eckförmig oder kosinusförmig verläuft.

7. Vorrichtung nach Anspruch 1, dadurch gekennzeichnet, daß die mittlere Gitterstrich-Verschiebung eines beliebigen Teilbereiches von mindestens zehn Gitterstrichen (n) kleiner 1/4 des mittleren Gitterstrichabstandes ist.

## Claims

1. Apparatus for deriving signals which are free from harmonics up to a predeterminable wavelength, which are generated by sensing a periodic measuring graduation (14) with at least one aperiodic sensing graduation (18), wherein the grating strokes of the sensing graduation (18) have a grating stroke displacement relative to the periodic measuring graduation (14), characterized in that the sequence of grating stroke displacements departs from an ordered sequence.

2. Apparatus according to claim 1, characterized in that the grating strokes (n) have the same width as each other.

3. Apparatus according to claim 1, characterized in that the irregular sequence of grating stroke displacements is determined by mixing up an ordered sequence.

4. Apparatus according to claim 3, characterized in that the mixing up is effected statistically or pseudo-statistically.

5. Apparatus according to claim 1, characterized in that the irregular sequence of grating stroke displacements is directly prescribed.

6. Apparatus according to any of claims 1 to 5, characterized in that the frequency distribution of the grating stroke displacements is of rectangular or cosinusoidal form.

7. Apparatus according to claim 1, characterized in that the mean grating stroke displacement of an arbitrary partial region of at least ten grating strokes (n) is smaller than 1/4 of the mean grating stroke spacing.

## Revendications

1. Dispositif pour la production de signaux exempts d'harmoniques jusqu'à une largeur de bande prédéterminée, lesquels signaux sont produits par palpage d'une graduation de mesure (14) périodique à l'aide d'au moins une graduation de lecture (18) apériodique, les traits de réseau de la graduation de lecture (18) présentant un décalage de traits de réseau par rapport à la graduation de mesure (14) périodique, caractérisé par le fait que la suite des décalages de traits de réseau n'est pas une suite ordonnée.

2. Dispositif selon la revendication 1, caractérisé par le fait que les traits de réseau (n) présentent la même largeur.

3. Dispositif selon la revendication 1, caractérisé par le fait que la suite irrégulière de décalages de traits de réseau est obtenue par brassage d'une suite ordonnée.

4. Dispositif selon la revendication 3, caractérisé par le fait que le brassage est opéré de manière statistique ou pseudo-statistique.

5. Dispositif selon la revendication 1, caractérisé par le fait que la suite irrégulière de décalages de traits de réseau est déterminée de manière directe.

6. Dispositif selon l'une des revendications 1 à 5, caractérisé par le fait que la courbe de distribution de fréquences des décalages de traits de réseau a une allure carrée ou sinusoïdale.

7. Dispositif selon la revendication 1, caractérisé par le fait que le décalage moyen des traits de réseau d'un zone quelconque comprenant au moins dix traits de réseau est inférieur à 1/4 de la distance moyenne entre les traits de réseau.

Fig. 1

Fig. 2

EP 0 645 607 B1

# Fig.3

# Fig.4

7